# DEMANDE DE BREVET EUROPEEN

(11) **EP 2 381 307 A1**
(43) Date de publication de la demande: **26.10.2011**
(21) Numéro de dépôt: 11163591.8
(22) Date de dépôt: 22.04.2011
(51) Int. Cl.: G03F 7/00

(54) **Dispositif et procédé de lithographie par microcontact**

(30) Priorité: 26.04.2010 FR 1053176
(71) Demandeur: INNOPSYS, 31390 Carbonne (FR)
(72) Inventeur: Cau, Jean-Christophe, 31400 Toulouse (FR); Lafforgue, Ludovic, 31360 Lestelle de St-Martory (FR)
(74) Mandataire: Hamann, Jean-Christophe

(57) **Abrégé**

L'invention concerne un dispositif et un procédé de lithographie douce par tamponnage utilisant un timbre souple pour réaliser un dépôt micro ou nano structuré de molécules sur un substrat tel qu'une plaque de verre destinée à l'observation microscopique. Elle permet un contrôle simple et efficace de la pression d'application d'un timbre ou d'un macro-timbre de lithographie douce à la surface d'un substrat et facilite l'automatisation du procédé de lithographie douce en y intégrant le changement de timbre automatique. À cette fin le dispositif comprend avantageusement un timbre souple comprenant une couche contenant des particules ferromagnétiques douces.

## Description

L'invention concerne un dispositif et un procédé de lithographie douce par tamponnage utilisant un timbre souple pour réaliser un dépôt structuré de molécules sur un substrat tel qu'une plaque de verre destinée à l'observation microscopique.

Des procédés de lithographie douce par tamponnage utilisant des timbres souples en élastomère permettant, par « encrage » et « tamponnage », de réaliser un dépôt structuré de molécules reproduisant le motif de la face du timbre sur un substrat, sont connus de l'art antérieur. Un tel procédé est décrit par exemple dans les documents EP2036604/US2009087019 au nom de la demanderesse.

La qualité du transfert, par contact, des molécules, réalisé par ce type de procédé, est fortement influencée par l'uniformité de la pression du timbre sur le substrat lors de l'opération de tamponnage et par la capacité de celui-ci à se conformer à la surface du substrat. S'agissant du dépôt de motifs moléculaires, micro ou nano structurés, l'uniformité de la pression est recherchée, à la fois, à une échelle macroscopique et à une échelle dimensionnelle microscopique. La qualité d'impression sera ainsi sensible à des irrégularités de surface dont l'ordre de grandeur se situe dans les paramètres de rugosité ou d'ondulation d'une telle surface, ou plus précisément des irrégularités qui sont révélées sur une surface S-L selon la norme ISO 25 178. Une grande souplesse du timbre est un avantage en regard de sa capacité à épouser la forme de la surface du substrat mais constitue cependant un inconvénient lorsqu'il s'agit de soumettre le timbre à des efforts visant à le plaquer de manière uniforme contre ladite surface, particulièrement à l'aide de moyens mécaniques transmettant ces efforts par contact avec le timbre. Des solutions de l'art antérieur emploient à cette fin des dispositifs de plaquage par pression gazeuse ou par le vide. De tels dispositifs de plaquage impliquent que soit réalisée l'étanchéité entre le timbre et lesdits dispositifs de plaquage. La complexité de ces dispositifs rend difficile le changement automatisé de timbre et par conséquent la réalisation entièrement automatisée et productive de dépôts complexes par cette technique.

Ainsi, l'invention vise un dispositif de lithographie douce disposant d'une capacité de changement de timbre automatisée, tout en offrant une qualité de transfert élevée par l'application d'une pression de plaquage uniforme et contrôlée du timbre sur le substrat lors de l'opération de tamponnage.

Dans un domaine éloigné de celui de l'invention, concernant les timbres utilisés pour le tamponnage de textes ou de dessins ; le document US-B-6 920 825 décrit un timbre comprenant une surface structurée, dite d'impression, sur l'une de ses faces, et une couche d'élastomère s'étendant sur une face opposée à la face d'impression, laquelle couche comprenant des fils ferromagnétiques. Ces fils ferromagnétiques permettent de lier, par effet magnétique, ledit timbre à un support, dit de préhension, pour appliquer le tampon et réaliser l'impression. Ainsi, un seul support de préhension peut être utilisé pour toute une collection de timbres de cette constitution. Outre le fait que ce document ne concerne pas des timbres pour la réalisation de dépôts micro ou nano structurés, la technologie utilisée pour ce tampon est totalement inopérante pour résoudre le problème technique visé par la présente invention. En effet, le ferromagnétisme des fils permet de lier le timbre à son support de préhension, la pression sur le substrat étant alors appliquée mécaniquement, ce qui ne permet pas d'obtenir une pression uniforme à l'échelle visée.

Le document JP-A-2001-338445 décrit une méthode de gravure d'une matrice ou *« stamper* » pour le pressage d'un disque optique utilisant un maintien en position magnétique de ladite matrice, elle-même métallique, durant ladite opération de gravure.

Pour résoudre les inconvénients de l'art antérieur l'invention propose un dispositif de lithographie douce par transfert comprenant un timbre souple apte à réaliser un dépôt micro ou nano structuré sur un substrat, ledit timbre souple étant constitué :
- d'une couche en élastomère comprenant une surface structurée sur l'une de ses faces apte à réaliser le dépôt par transfert ; et
- d'une seconde couche en élastomère en liaison intime avec la face opposée à la surface structurée de la première couche laquelle seconde couche est constituée d'un élastomère dans lequel sont dispersées des particules constituées d'un matériau ferromagnétique doux.

La présence de ces particules ferromagnétiques douces permet d'appliquer une pression uniforme sur le timbre par l'application d'un champ magnétique approprié. L'action de ces particules se répartit dans tout le volume de la couche chargée en particules ferromagnétiques. Cette pression est appliquée au timbre sans contact, ni avec un actionneur mécanique, ni avec un fluide. Le timbre peut donc rester souple de sorte à épouser au mieux la surface du substrat. Les particules ferromagnétiques étant de type douces, elles ne conservent pas leur aimantation après que le champ magnétique auquel elles sont soumises n'est plus actif. Cette capacité d'aimantation et de désaimantation d'une couche du timbre souple par l'intermédiaire des particules ferromagnétiques douces qu'il contient, permet de manipuler celui-ci facilement par un électroaimant, sans contrainte d'étanchéité, et donc permet le changement facile de timbre y compris avec des timbres très souples et/ou de forme complexe.

L'invention peut être mise en oeuvre selon plusieurs modes de réalisation avantageux, décrits ci-après, lesquels peuvent être considérés individuellement ou selon toute combinaison techniquement opérante.

Avantageusement, la dimension des particules ferromagnétiques douces est comprise entre 10 µm et 200 pm. La finesse des particules permet d'assurer une pression uniforme du timbre sur le substrat à l'échelle visée. Dans tout ce document, 1 µm est équivalent à 10⁻⁶ mètres.

Le taux de particules dans la seconde couche est avantageusement compris entre 50 % et 95 % en masse. La finesse de ces particules permet d'obtenir ces taux élevés sans nuire à la souplesse du timbre.

L'élastomère constituant les deux couches du timbre est un PolyDiMéthylSiloxane (PDMS). Ce matériau permet des concentrations massiques élevées de particules ferromagnétiques douces tout en conservant des propriétés mécaniques adaptées à son utilisation en tant que constituant du timbre. La fabrication du timbre est effectuée en deux moulages successifs consistant en une première étape de moulage et de réticulation partielle de la première couche comprenant les motifs de structuration du dépôt, sans injection de particules, puis, le moulage au-dessus de la première couche de la seconde couche laquelle comprend des particules ferromagnétiques prémélangées. La finesse des particules fait que celles-ci ne nuisent pas à la polymérisation du timbre et qu'elles restent en suspension, réparties de manière uniforme dans la seconde couche, au cours de cette polymérisation.

Avantageusement le dispositif comprend des moyens de manipulation magnétiques aptes à la préhension et la dépose du timbre souple, de sorte à permettre un changement de timbre automatisé.

Le dispositif comprend avantageusement un générateur de champs magnétiques placé sous le substrat et des moyens de pilotage de ce générateur de sorte à déclencher et ajuster la force de pression du timbre sur le substrat. Le placement du générateur de champs magnétiques sous le substrat permet d'obtenir un effet de plaquage optimal du timbre sur la surface dudit substrat même en cas d'utilisation d'un macro-timbre, tel que décrit dans les demandes EP2036604/US2009087019, ledit macro-timbre comportant une couche contenant des particules ferromagnétiques douces.

Le type de générateur de champs magnétiques placé sous le substrat ainsi que son mode de pilotage sont choisis en fonction de la nature du substrat, de son épaisseur, de sa surface et de la nature du timbre utilisées.

Selon un mode de réalisation particulier, le générateur de champs magnétiques est un aimant et les moyens de pilotage agissent sur la distance entre ledit aimant et le timbre. Ledit aimant peut être constitué par un aimant permanent, un électroaimant ou un solénoïde l'un ou l'autre étant alimentés par un courant électrique de tension et d'intensité fixes.

Selon un autre mode de réalisation, le générateur de champs magnétiques comprend un solénoïde et les moyens de pilotage agissent sur l'intensité ou la tension d'alimentation électrique dudit solénoïde.

Selon un mode de réalisation particulièrement avantageux, le dispositif comprend une électrode placée entre le générateur de champs magnétiques et le substrat, et des moyens aptes à mesurer la variation de capacité entre ladite électrode et la seconde couche du timbre. Cette caractéristique permet de contrôler, en temps réel, la force de plaquage du timbre sur le substrat et de piloter le générateur de champs magnétiques en conséquence. Cette facilité de contrôle est offerte par la présence des particules ferromagnétiques dans le timbre, lesquelles augmentent la conductivité électrique de celui-ci, rendant ainsi possible ce type de mesure avec un timbre constitué d'un polymère essentiellement non conducteur.

Le dispositif de l'invention peut ainsi être entièrement automatisé, les moyens magnétiques de préhension et de dépose étant supportés par des chariots croisés aptes à déplacer lesdits moyens selon 3 axes orthogonaux. En lui adjoignant un bac d'encrage et un support pour substrat, les chariots croisés permettent de déplacer les moyens magnétiques de préhension entre le bac d'encrage et le support pour substrat.

Avantageusement le dispositif peut comporter plusieurs bacs d'encrage, ou puits, contenant des produits différents à déposer sur le substrat. La capacité de changer de timbre permet de disposer de différents timbres pour déposer différents produits sans opération intermédiaire de nettoyage des timbres et ainsi d'augmenter fortement la productivité de l'opération de lithographie douce.

À ce titre, l'invention concerne également un procédé avantageux et optimisé de lithographie douce mis en oeuvre à l'aide du dispositif de l'invention, lequel procédé comprend les étapes consistant à :
- prendre le timbre par les moyens magnétiques de préhension
- déplacer le timbre au-dessus du bac d'encrage et mettre la face structurée du timbre en contact avec le contenu du bac
- sortir le timbre du bac
- amener le timbre au-dessus du substrat
- libérer le timbre des moyens de préhension magnétiques
- appliquer uniformément le timbre sur le substrat en activant le générateur de champs magnétique placé sous le substrat.

L'invention sera maintenant plus précisément décrite dans le cadre de modes de réalisation préférés, nullement limitatifs, représentés sur les figures 1 à 7, dans lesquelles :
- la figure 1 représente un timbre pour lithographie douce de face et en coupe ;
- la figure 2 montre un macro-timbre pour lithographie douce, vu de face et en coupe ;
- la figure 3 est une vue de face et en coupe de l'ensemble timbre et substrat ainsi que des éléments permettant de transporter le timbre et de l'appliquer sur le substrat pour l'impression ;
- la figure 4 est une vue de dessus en perspective d'un dispositif automatisé de lithographie douce ;
- la figure 5 représente selon une vue de droite en perspective un détail du dispositif précédent, comprenant un macro-timbre et ses moyens de préhension ;
- la figure 6 représente une vue de face et en coupe des différentes étapes d'application d'un timbre sur un substrat, incluant une étape, figure 6C, d'application d'une force de plaquage trop élevée sur ledit timbre ;
- et la figure 7 montre l'évolution de la capacité d'un condensateur formé entre la seconde couche du timbre et une électrode placée sous le substrat.

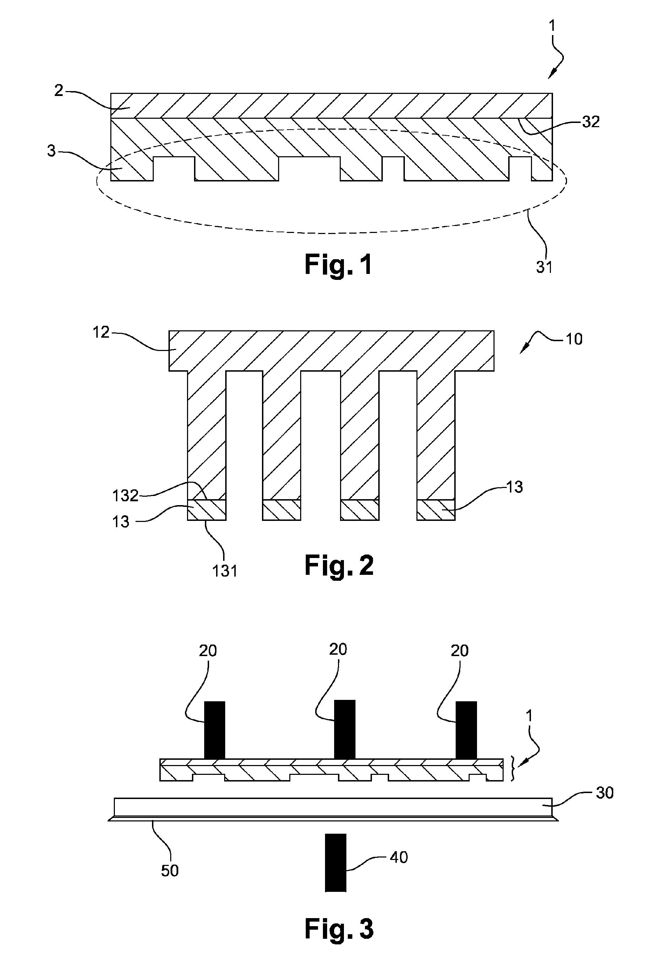

Figure 1, selon un mode de réalisation d'un timbre (1) de lithographie douce, celui-ci est constitué en PDMS et comprend selon son épaisseur une première couche (3) laquelle comprend une face micro ou nano structurée, dite d'impression (31), apte à réaliser un dépôt par transfert sur un substrat, et une deuxième face (32), sensiblement parallèle et opposée à la première. Une seconde couche (2), en liaison intime avec la première couche (3) le long de la deuxième face (32), est également constituée de PDMS lequel est chargé en particules ferromagnétiques douces, telles que des particules de ferrite, c'est-à-dire, une céramique contenant essentiellement de l'oxyde de fer (III) (Fe₂O₃) du manganèse et du zinc. Alternativement il est possible d'utiliser des particules de fer pur, éventuellement protégées de l'oxydation, des particules constituées d'alliages fer-nickel-molybdène tel que le SuperMalloy® ou de fer-silicium, et d'une manière générale tout matériau ferromagnétique doux, c'est-à-dire qui s'aimante sous l'action d'un champ magnétique et dans lequel ne subsiste pas d'aimantation rémanente lorsqu'il n'est plus soumis à ce champ. Les matériaux ferromagnétiques doux présentent par ailleurs une faible perméabilité magnétique. Ainsi ils offrent un bon compromis entre :
- la réaction à un champ magnétique et la possibilité de générer une force d'attraction magnétique, notamment du timbre vers le substrat ;
- une perméabilité magnétique suffisamment faible de sorte que les mêmes dispositifs d'attraction magnétique peuvent être utilisés pour une large variété de timbres, avec des performances d'uniformité de pression comparables ;
- une réaction rapide à l'excitation magnétique et au retrait de cette excitation, autorisant ainsi des cadences de d'encrage-transfert élevées ;
- l'absence d'aimantation rémanente suite à l'utilisation qui évite que le timbre n'attire des pollutions telles que des poussières métalliques lors de son stockage.

Ces particules sont sensiblement sphériques d'un diamètre compris entre 10 µm et 200 µm.

Figure 2, selon un mode de réalisation d'un macro-timbre (10), celui-ci comprend une pluralité de timbres (13) comprenant chacun une face d'impression (131) et une face opposée (132) laquelle est en liaison intime avec le corps du macro-timbre (12). Les timbres (13) sont préférentiellement constitués de PDMS. Le corps (12) est constitué de PDMS chargé entre 50 % et 95 % en poids de particules ferromagnétiques douces. La perméabilité magnétique des particules ferromagnétiques douces ainsi que l'absence d'aimantation rémanente dans les couches comprenant ces particules ferromagnétiques, permettent ces associations de timbres en macro-timbres sans difficulté d'interactions magnétiques entre les différents timbres.

Le principe de fabrication d'un timbre ou d'un macro-timbre selon ces modes de réalisation est sensiblement le même. Une première étape de moulage des couches (3, 13) comprenant les motifs micro ou nano-structurés et ne contenant pas de particules de ferromagnétiques est réalisée. Cette étape de moulage est suivie d'une réticulation partielle, par exemple par une précuisson à 60 °C pendant 15 minutes, de ladite couche. Puis, la couche (2, 12) contenant les particules ferromagnétiques est surmoulée sur cette première couche. Les deux couches sont ensuite co-cuites. La première réticulation partielle évite tout mélange entre les deux couches lors du surmoulage de la couche chargée en particules ferromagnétiques tout en conservant la capacité d'accrochage d'une couche à l'autre lors de l'étape de co-cuisson ultérieure.

La présence des particules ferromagnétiques permet de rendre sensible à un champ magnétique la couche (2, 12) dans laquelle elles sont contenues et d'utiliser cette propriété pour manipuler le timbre.

La présence de ces particules modifie également la conductibilité électrique de la couche, réduisant sa résistance électrique à quelques dizaines de milliers d'ohms.

La modification de ces propriétés est mise à profit pour automatiser le procédé de lithographie douce.

Figure 3, selon un exemple de réalisation, la présence d'une couche ferromagnétique (2, 12) permet la préhension du timbre (1) ou du macro-timbre (10) par des dispositifs comprenant des bobines ou solénoïdes (20) susceptibles de produire un champ magnétique. Lorsque lesdites bobines sont alimentées en courant électrique, elles produisent un champ magnétique, lequel permet d'attirer le timbre (1) ou le macro-timbre (10), et une fois celui-ci collé aux bobines (20), de le déplacer. Pour appliquer le timbre (1) sur un substrat (30), par exemple une lame de verre, l'alimentation électrique des bobines est interrompue. Un dispositif générateur d'un champ magnétique (40), placé sous le substrat (30), tend à attirer et à plaquer le timbre ou le macro-timbre sur ledit substrat l'obligeant ainsi à se conformer à la surface dudit substrat. La force appliquant le timbre (1) sur le substrat (30) peut être contrôlée selon différents modes en fonction de la nature du dispositif générateur de champ magnétique (40). À titre d'exemple non limitatif :
- le dispositif générateur de champ magnétique (40) peut être constitué par un aimant permanent, l'ajustement de la force de plaquage est alors réalisé par la distance entre le timbre (1) et l'aimant, soit en déplaçant l'aimant, soit en déplaçant le timbre ;
- ledit dispositif (40) peut être réalisé par une bobine ou solénoïde, et l'ajustement de la force de plaquage est alors réalisé en faisant varier l'intensité ou la tension de l'alimentation électrique de la bobine ;
- ledit dispositif (40) peut être réalisé par un électroaimant c'est-à-dire par un solénoïde entourant un aimant, l'ajustement est alors réalisé par le réglage de l'intensité du courant d'alimentation électrique du solénoïde et/ou la distance entre le timbre et l'électroaimant.

L'ajustement de la force peut être piloté par la surface effective de contact entre le timbre (1) et le substrat. Pour estimer cette surface de contact, une électrode (50) est avantageusement placée entre le dispositif générateur de champs magnétique (40) et le substrat (30). En mettant à profit la conductivité électrique de la couche (2, 12) chargée en particules ferromagnétiques, on peut ainsi mesurer la variation de capacité représentant la quantité d'air, isolant, présente entre le timbre (1) et le substrat (30), laquelle quantité est proportionnelle à la surface de contact effective entre le timbre et le substrat. Cette mesure offre l'avantage de ne pas être influencée par le champ magnétique.

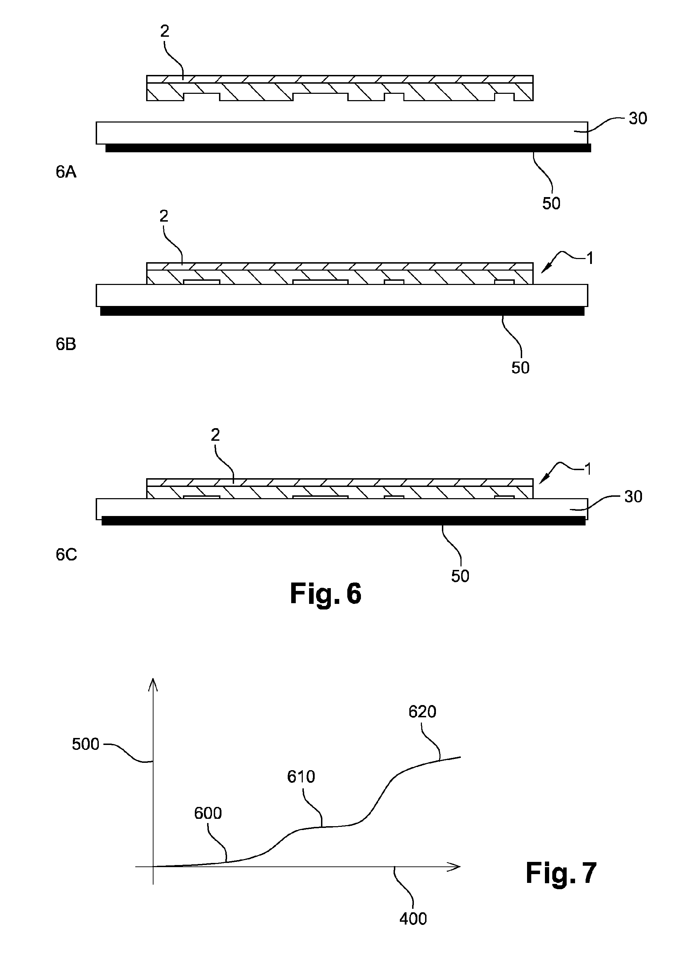

Figure 6, l'électrode (50) placée entre le dispositif générateur de champs magnétiques et le substrat (30), constitue un condensateur avec la seconde couche (2, 12) du timbre, laquelle est chargée de particules ferromagnétiques, et la lame d'air diélectrique séparant les deux. En mesurant la variation de capacité de ce condensateur ou la variation de capacitance d'un circuit électrique intégrant ce condensateur, lesquelles variations sont influencées par l'épaisseur de la lame d'air, il est possible d'obtenir un signal caractéristique de la force de plaquage du timbre (1, 10) sur le substrat (30).

Ainsi, figure 6A, lorsque le timbre (1) n'est pas en contact avec le substrat la capacité du condensateur formée par l'électrode (50) placée sous le substrat et la seconde couche (2) est faible. Figure 6B, lorsque la distance entre les deux électrodes diminue, la capacité augmente pour atteindre un palier.

La figure 7 représente l'évolution (600) de la capacité (500) dudit condensateur en fonction de la force de plaquage (400) du timbre sur le substrat. La capacité atteint un premier palier (610) lequel correspond expérimentalement à une force de plaquage optimale du timbre (1) ou du macro-timbre (10) sur le substrat (30).

Figure 6C, si la force de plaquage devient trop importante, il y a écrasement du timbre et augmentation importante de la capacité du condensateur, laquelle croît jusqu'à un palier correspondant à l'écrasement complet du timbre (1) sur le substrat.

Figure 7, le second palier (620) dans l'évolution de la capacité correspond à l'écrasement du timbre.

Ainsi en suivant l'évolution de la capacité du condensateur formé par l'électrode (50) et la seconde couche, il est possible de piloter le générateur de champs magnétiques de sorte à obtenir une force de plaquage optimale, correspondant au premier palier (610) dans l'évolution mesurée de cette capacité.

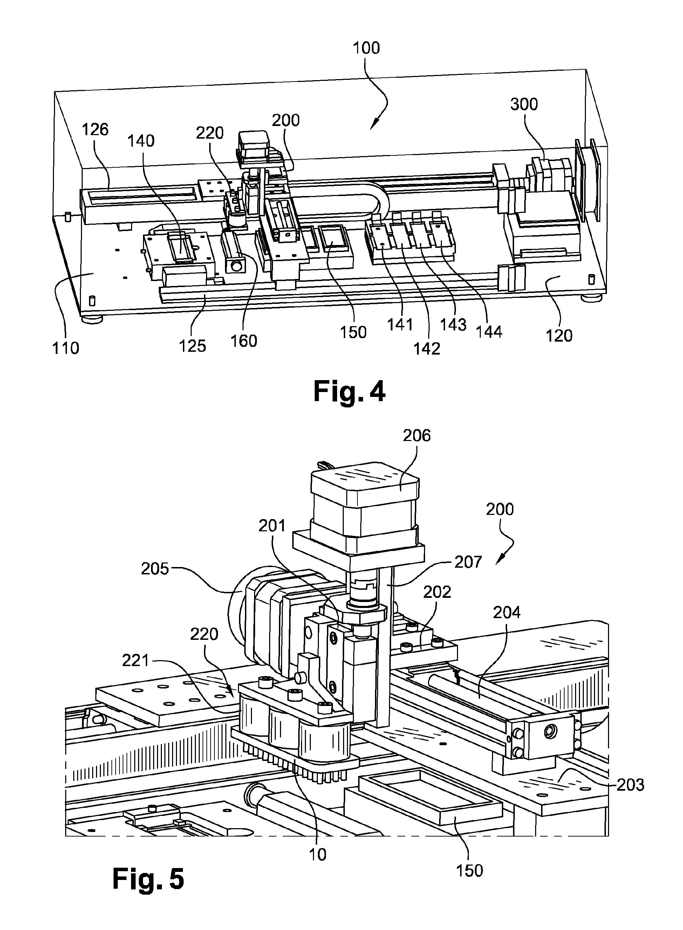

Figure 4, selon un mode de réalisation d'un dispositif automatisé de lithographie douce (100), celui-ci comprend une table (120), sur laquelle sont fixés des guidages (125, 126) supportant un portique (200). Ledit portique est apte à se déplacer en translation par rapport à la table (120) selon un axe longitudinal matérialisé par lesdits guidages (125, 126) et grâce à des moyens de motorisation (300). Le portique supporte un dispositif de préhension magnétique (220) de timbres ou de macro-timbres (10), qui peuvent ainsi se déplacer longitudinalement par rapport à la table (120) avec le portique (200). Selon son axe longitudinal, la table supporte 5 postes correspondant aux différentes opérations nécessaires à un dépôt par tamponnage.

Le premier poste (110) correspond à une zone de stockage de timbres ou de macro-timbres. Grâce au dispositif de préhension magnétique (220) il est en effet possible d'utiliser différents timbres et de réaliser ces changements de timbres de manière automatique.

Le deuxième poste (140) est une zone de dépôt apte à recevoir un substrat sous la forme par exemple d'une lame. Ce poste est avantageusement équipé d'un électroaimant placé sous ladite lame pour assurer une pression uniforme du timbre ou du macro-timbre sur la surface du substrat lors du tamponnage.

Le troisième poste (160) est une zone de séchage du timbre ou du macro-timbre par soufflage d'air.

Le quatrième poste (150) est un poste dit « d'encrage ». Il comprend plusieurs bacs contenant des solutions ou des molécules à déposer sur le substrat. Un des bacs peut également contenir une solution de nettoyage du timbre ou du macro-timbre.

Le cinquième poste (141, 142, 143, 144) comprend d'autres substrats destinés à recevoir des dépôts structurés. Dans cet exemple de réalisation, celui-ci peut accueillir jusqu'à quatre lames. Selon un mode de réalisation, le dispositif générateur de champs magnétiques associé à ce poste est constitué par des aimants permanents.

Figure 5, le portique (200) comprend une traverse (203) laquelle repose sur les guidages (125, 126). Elle supporte des éléments de guidage (204) et des éléments de motorisation (205) qui permettent le déplacement d'un chariot (202), dit chariot transversal, parallèlement à ladite traverse (203), c'est-à-dire perpendiculairement à la direction longitudinale de la table (120), selon une direction dite transversale.

Le chariot transversal (202) supporte des éléments de guidage (207) s'étendant selon une direction, dite verticale, perpendiculaire aux directions longitudinales et transversales, et des éléments de motorisation (206) permettant de déplacer un chariot (201) dit vertical, supportant le dispositif de préhension magnétique (220).

Le dispositif de préhension magnétique est constitué de trois solénoïdes (221), lesquels, lorsqu'ils sont alimentés en courant électrique, sont aptes à porter un macro-timbre (10) ou un timbre, d'un poste à l'autre.

Alternativement le dispositif de préhension peut être constitué de trois électroaimants, lesquels génèrent un champ magnétique apte à porter le timbre même sans être alimentés en courant électrique. Dans cet exemple de réalisation, l'alimentation électrique des solénoïdes des électroaimants permet de libérer le timbre. Ce mode de réalisation est avantageusement utilisé pour les timbres très souples et légers. Pour les timbres plus lourds ou les macro-timbres, l'alimentation inversée en courant du solénoïdes permet d'augmenter la force d'attraction.

Ainsi après avoir pris un timbre (1) ou un macro-timbre (10), le dispositif amène d'abord celui-ci au poste d'encrage (150) où il est plongé dans un des bacs. L'encrage a lieu par trempage du timbre dans un des bacs. Avantageusement le dispositif de préhension magnétique permet de faire osciller le timbre dans les bains en modulant l'alimentation des solénoïdes lors du trempage de sorte à favoriser l'uniformité de l'encrage.

Le timbre, accroché aux moyens de préhension magnétiques (220), est ensuite amené au-dessus de la zone de séchage (130). Il est ensuite appliqué sur l'une des lames et ainsi de suite. Alternativement, il est possible de changer de timbre d'une opération de tamponnage à l'autre.

La description ci-avant illustre clairement que par ses différentes caractéristiques et leurs avantages, la présente invention atteint les objectifs qu'elle visait. En particulier, elle permet un contrôle simple et efficace de la pression d'application d'un timbre ou d'un macro-timbre de lithographie douce à la surface d'un substrat et facilite l'automatisation du procédé de lithographie douce en y intégrant le changement de timbre automatique. L'invention est plus particulièrement adaptée à la réalisation de biopuces.

## Revendications

1. Dispositif (100) de lithographie douce par transfert d'un dépôt micro ou nano structuré sur un substrat (30) **caractérisé en ce qu'**il comprend un timbre souple (1,10) constitué :
- d'une couche en élastomère (3, 13) comprenant une surface structurée (31, 131) sur l'une de ses faces apte à réaliser le dépôt par transfert ; et
- d'une seconde couche (2, 12) en élastomère en liaison intime avec la face (32, 132) opposée à la surface structurée (31, 131) de la première couche (3, 13) laquelle seconde couche (2, 12) est constituée d'un élastomère dans lequel sont dispersées des particules constituées d'un matériau ferromagnétique doux.

2. Dispositif selon la revendication 1, **caractérisé en ce que** la dimension des particules ferromagnétiques douces dispersées dans la seconde couche (2, 12) est comprise entre 10 µm et 200 µm.

3. Dispositif selon la revendication 2, **caractérisé en ce que** la proportion de particules ferromagnétiques douces dans la seconde couche (2, 12) du timbre (1, 10) est comprise entre 50 % et 95 % en masse.

4. Dispositif selon la revendication 1, **caractérisé en ce que** l'élastomère constituant les deux couches du timbre est un PolyDiMéthylSiloxane (PDMS).

5. Dispositif selon la revendication 1, **caractérisé en ce qu'**il comprend des moyens magnétiques (20, 221) aptes à la préhension et la dépose du timbre souple (1,10).

6. Dispositif selon la revendication 1, **caractérisé en ce qu'**il comprend un générateur (40) de champs magnétiques placé sous le substrat (30) et des moyens de pilotage du générateur de sorte à déclencher et ajuster la force de pression du timbre sur le substrat.

7. Dispositif selon la revendication 6, **caractérisé en ce qu'**il comprend une électrode (50) placée entre le générateur (40) de champs magnétiques et le substrat (30) et des moyens aptes à mesurer la variation de capacité électrique entre ladite électrode (50) et la seconde couche (2, 12) du timbre (1, 10).

8. Dispositif selon la revendication 6, **caractérisé en ce que** le générateur (40) de champs magnétiques est un aimant et que les moyens de pilotage agissent sur la distance entre ledit aimant et le timbre.

9. Dispositif selon la revendication 6, **caractérisé en ce que** le générateur de champs magnétique comprend un solénoïde et que les moyens de pilotage agissent sur l'intensité ou la tension d'alimentation électrique dudit solénoïde.

10. Dispositif selon les revendications 5 et 6, **caractérisé en ce que** les moyens magnétiques de préhension et de dépose sont supportés par des chariots croisés (201, 202, 203) aptes à déplacer lesdits moyens selon 3 axes orthogonaux et qu'il comprend un bac d'encrage (150) et un support pour substrat (140, 141, 142, 143, 144), les chariots croisés permettant de déplacer les moyens magnétiques de préhension (220) entre le bac d'encrage et le support pour substrat.

11. Procédé de lithographie douce mis en oeuvre à l'aide d'un dispositif selon la revendication 10 **caractérisé en ce qu'**il comprend des étapes consistant à :
- prendre le timbre (1, 10) par des moyens magnétiques de préhension (220) ; et
- déplacer le timbre au-dessus d'un bac d'encrage (150) et mettre la face micro ou nano structurée (32, 132) du timbre en contact avec le contenu du bac ; et
- sortir le timbre du bac ; et
- amener le timbre au-dessus d'un substrat (30) ; et
- libérer le timbre des moyens de préhension magnétiques ; et
- appliquer uniformément le timbre (1, 10) sur le substrat (30) en activant un générateur (40) de champs magnétiques placé sous le substrat (30).
